# EUROPEAN PATENT APPLICATION

(11) **EP 2 540 667 A1**
(43) Date of publication of application: **02.01.2013**
(21) Application number: 11171687.4
(22) Date of filing: 28.06.2011
(51) Int. Cl.: C01F 5/28, C03C 17/22, C07C 53/10, H01L 31/0216

(54) **Method for the manufacture of magnesium fluoride sols and magnesium fluoride sol**

(71) Applicant: SOLVAY SA, 1120 Bruxelles (BE)
(72) Inventor: The designation of the inventor has not yet been filed
(74) Representative: Mross, Stefan P.M.

(57) **Abstract**

A method is described to produce magnesium fluoride sols in an alcohol, especially in ethanol, with improved properties by the reaction of magnesium acetate or magnesium alcoholate with HF in C1 to C3 aliphatic alcohol or C2 or C3 aliphatic diol, preferably ethanol, in the presence of a specific amount of water.

Improved magnesium fluoride sols are also described. The sols are useful to provide coatings of MgF₂ on solar cells.

The invention also provides solutions containing magnesium acetate, specific organic solvents, carbon dioxide and optionally water.

## Description

The invention concerns a method for the manufacture of magnesium fluoride sols and improved magnesium fluoride sols. The invention also concerns solutions of magnesium acetate in specific organic solvents.

It is known that a low refractive magnesium fluoride coating on the top of solar cells minimizes light losses through reflection. See Olga Panathasiou in PHOTON International, October 2008, pages 66 to 68. MgF₂ coatings can also be applied as anti-reflective coating on spherical photovoltaic cells, see US patent 6,204,545.

Magnesium fluoride sols can be applied to produce MgF₂-optical coatings, see for example, John D. Bass, Cédric Boissiere, Lionel Nicole, David Grosso and Clément Sanchez in Chem. Mater., 2008, 20, pages 5550 - 5556. These authors mention the formation of magnesium oxofluoride coatings by providing a solution obtained by mixing magnesium acetate tetrahydrate, ethanol, water and trifluoroacetic acid, deposition of a layer of this solution on Si wafers and calcination at 450°C.

The manufacture of metal fluoride sols and metal fluoride gels is described in DE patent application publication DE 102006017582 (Kemnitz et al.). A metal, e.g. magnesium, reacted with a solution of HF in an non-aqueous solvent to form a metal fluoride sol. By removing solvent, the sol can be transformed into a gel. The metal fluoride sols and metal fluoride gels obtained can be used to provide protective coatings and antireflective coatings, for example, via the "Dip Coating" or "Spin Coating" technique.

Johannes Noack, Katharine Teinz, Christian Schaumberg, Carsten Fritz, Stephan Rüdiger und Erhard Kemnitz describe in J. Mater. Chem., 2011, 21, pages 334 to 338, the manufacture of clear magnesium fluoride sols by dissolution of magnesium chips in dry methanol and fluorination with 2 equivalents of anhydrous HF dissolved in methanol.

Object of the present invention is to provide a method to obtain an magnesium fluoride sol. Another object of the present invention is to provide a method to obtain a stable magnesium fluoride sol. Still another object of the present invention is to provide a stable magnesium fluoride sol. A further object is to provide improved solutions of magnesium acetate in organic solvents. These and other objects are achieved by the method and sols of the present invention.

The method of the present invention for the manufacture of a magnesium fluoride sol by reaction of magnesium acetate or magnesium alcoholate and HF comprises a step of providing a solution comprising HF which contains water and Mg(Ac)₂ or magnesium alcoholate in a molar ratio from about 1:1 to about 3:1, preferably from about 1.7:1 to about 2.7:1 in a C1 to C3 aliphatic alcohol or C2 to C3 aliphatic diol, preferably in ethanol, wherein the alcoholate is selected from methanolate, ethanolate and propanolate.

Thus, according to one embodiment, the method of the present invention for the manufacture of a magnesium fluoride sol applies the reaction between magnesium alcoholate and HF and comprises a step of providing a solution which solution comprises HF, and which solution further contains water and magnesium alcoholate in a molar ratio from about 1:1 to about 3:1, preferably from about 1.7:1 to about 2.7:1, in a C1 to C3 aliphatic alcohol or C2 to C3 aliphatic diol, preferably in ethanol, wherein the alcoholate is selected from methanolate, ethanolate and propanolate. In this embodiment, the term propanolate denotes n-propanolate and i-propanolate, preferably i-propanolate. According to this embodiment, HF and magnesium ethanolate and water are provided in ethanol, the molar ratio between water and magnesium ethanolate being as given above.

According to another embodiment which is preferred, the method of the present invention for the manufacture of a magnesium fluoride sol by reaction of magnesium acetate and HF comprises a step of providing a solution comprising HF which solution further contains water and Mg(Ac)₂ in a molar ratio from about 1:1 to about 3:1, preferably from about 1.7:1 to about 2.7:1 in a C1 to C3 aliphatic alcohol or C2 to C3 aliphatic diol, preferably in ethanol.

The invention will now be described in view of this preferred embodiment wherein magnesium acetate is reacted with HF ; the molar ratio between water and Mg(Ac)₂ being from about 1:1 to about 3:1, preferably from about 1.7:1 1 to about 2.7:1.

The sol can be manufactured in a C1 to C3 aliphatic monohydroxy alcohol, especially in methanol, ethanol and isopropanol. It can also be manufactured in a C2 or C3 aliphatic diol, especially in ethanediol. It can also be produced in any mixtures of said C1 to C3 aliphatic alcohols and C2 and C3 aliphatic diols.

Preferably, it is manufactured in ethanol. The invention will now be described in view of this especially preferred embodiment.

The term "magnesium acetate" in the frame of the present invention denotes anhydrous magnesium acetate, magnesium acetate tetrahydrate, partially dehydrated magnesium acetate and any mixtures thereof.

The term "anhydrous magnesium acetate"denotes magnesium acetate which, if at all, contains only undesired amounts of water, e.g. up to 0.1 moles water per mole magnesium acetate. The term "magnesium acetate tetrahydrate"denotes magnesium acetate which contains at least 3.9 moles of water per mole magnesium acetate. The term "partially dehydrated magnesium acetate" denotes preferably magnesium acetate which contains more than 1 and less than 3 moles water per mole of magnesium acetate. Such partially dehydrated magnesium acetate can be obtained by heating magnesium acetate tetrahydrate to higher temperatures, e.g. up to 200°C or more, for a time sufficient to reduce the content of water to the desired amount.

The term "Mg(Ac)₂"is applied to calculate the molar ratio between water and magnesium acetate molecules in the solution. For the calculation of the molar ratio, magnesium acetate molecules originating from anhydrous magnesium acetate and magnesium acetate tetrahydrate and any intermediate magnesium acetate compounds are taken into calculation.

The term "about [figure]" in the frame of the present invention preferably denotes the figure itself. Thus, "about 2:1 to about 2.5:1" preferably means "2:1 to 2.5:1".

Preferably, at least a part of the magnesium acetate is introduced into the reaction in the form of magnesium acetate tetrahydrate.

Preferably, at least a part of the magnesium acetate is introduced into the reaction in the form of anhydrous magnesium acetate.

Generally, the molar ratio between fluoride anions and magnesium cations is equal to or greater than about 1.5.

Generally, the molar ratio between fluoride anions and magnesium cations in the solution is equal to or lower than about 1.95:1.

Generally, the concentration of magnesium fluoride in the resulting magnesium fluoride sol is from about 0.35 to about 0.55 Mol/liter.

There are several alternatives to introduce the water which is present in the reaction mixture.

According to a first alternative, the water content is introduced in the form of partially dehydrated magnesium acetate. Such partially dehydrated magnesium acetate can be obtained, as mentioned above, by heating the tetrahydrate for a time sufficient to provide the partially dehydrated magnesium acetate with the desired residual content of water. It is assumed that such partially dehydrated magnesium acetate contains anhydrous magnesium acetate, magnesium acetate tetrahydrate or magnesium acetate with intermediate contents of crystal water. It is often difficult to reliably achieve a product with the desired amount of water, and thus, this alternative is not preferred.

According to an second alternative, the water is added as such to the reaction mixture - but this is not a preferred way - or in the form of aqueous HF or aqueous ethanol or both.

According to a third alternative, the water content is introduced into the reaction mixture by applying anhydrous magnesium acetate and magnesium acetate tetrahydrate in appropriate amounts. This alternative is preferred because because it allows the reliable introduction of the desired amount of water. The following table 1 provides information about the amounts of magnesium acetate tetrahydrate and anhydrous magnesium acetate which must be entered into the reaction to provide a desired molar ratio of water and "Mg(Ac)₂".

**Table 1 : Amounts of anhydrous magnesium acetate and magnesium acetate tetrahydrate to be introduced into the reaction to provide a desired molar ratio between water and "Mg(Ac)₂"**

| Desired molar ratio H₂O:Mg(Ac)₂ | Amount of magnesium acetate tetrahydrate | Amount of anhydrous magnesium acetate |
|---|---|---|
| 1:1 | 1 mol | 3 mol |
| 3:1 | 3 mol | 1 mol |
| 1.7:1 | 1.7 mol | 2.3 mol |
| 2.7:1 | 2.7 mol | 1.3 mol |
| 2:1 | 2 mol | 2 mol |
| 2.5:1 | 2.5 mol | 1.5 mol |

Of course, two or more alternatives may be combined to introduce the water into the reaction mixture but this is considered to be complicated.

In a preferred embodiment, essentially all of the water is introduced in the form of crystal water contained in the magnesium acetate tetrahydrate (except of any trace amount of water in the ethanol, anhydrous magnesium acetate and/or HF applied).

There are several alternatives to introduce the HF into the reaction mixture.

For example, it can be introduced in the form of gaseous HF or, as mentioned above, in the form of aqueous HF (hydrofluoric acid) if all or a part of the water is introduced into the reaction in this way. Preferably, the HF is introduced into the reaction mixture in the form of a solution of HF in ethanol. Preferably, the HF is contained in the ethanol/HF solution in a concentration of 5 to 15 % by weight, preferably 10±2 % by weight, relative to the total amount of HF and ethanol.

As mentioned above, at least a part of the magnesium acetate is introduced into the reaction in the form of anhydrous magnesium acetate.

The anhydrous magnesium acetate is suspended in the ethanol. This can be time consuming because the anhydrous magnesium acetate is not very soluble. Surprisingly, it was found that the dissolution of the anhydrous magnesium acetate or the partially dehydrated magnesium acetate can be accelerated by the presence of carbon dioxide in the ethanol. Thus, in a preferred embodiment, the anhydrous magnesium acetate is dissolved in a solution of carbon dioxide in ethanol. The carbon dioxide evaporates from the resulting solution when HF is added. The content of carbon dioxide in the ethanol is preferably from 0.1 to 10 % by weight of the total amount of carbon dioxide and ethanol. In this embodiment, solutions can be obtained which contain up to 10 % by weight of dissolved solid.

If carbon dioxide is applied, it is preferred to perform the reaction with HF within a short time span because the resulting solution of the magnesium acetate is not stable for a long time.

Preferably, no trifluoroacetic acid is present in the reaction mixture.

The method described above provides magnesium fluoride sols which have improved properties compared to magnesium fluoride sols obtained according to other methods. For example, the sols are longer resistant to a transformation into solid gels, they contain preferably no trifluoroacetic acid, and they do settle.

A preferred method provides stable magnesium fluoride sols. The term "stable" denotes, int the context of the present invention, magnesium fluoride sols which do not undergo a transformation into a solid gel when stored at ambient temperature (about 20°C) for at least 1 week and even longer ; it is expected the sols are stable for at least 1 month.

To provide such stable sols, water and Mg(Ac)₂ are preferably present in the solution in a molar ratio from about 1:1 to about 3:1, more preferably, from about 1.7:1 to about 2.7:1, and most preferably, from about 2:1 to about 2.5:1. The molar ratio between fluoride anions and magnesium cations in the solution is between about 1.7:1 to about 1.9:1. The concentration of magnesium fluoride in the stable sols is preferably from about 0.4 to 0.5 Mol / liter. The concentration may, if desired, even greater than 0.5 Mol/liter.

In the following, the best mode for providing magnesium fluoride sols is described.

Magnesium acetate tetrahydrate is partially dehydrated to the desired residual water content which preferably is 2 to 2.5. Alternatively, magnesium acetate tetrahydrate and anhydrous magnesium acetate are applied in respective amounts ; see for example, above in table 1. The magnesium acetate or magnesium acetates are suspended and dissolved in ethanol which may comprise carbon dioxide to improve the speed of dissolution of the anhydrous magnesium acetate. To the resulting solution containing magnesium acetate and ethanol and, if applied, carbon dioxide, a solution of HF in ethanol, preferably comprising HF in a concentration of 10±2 % by weight, is added in an amount corresponding to the provision concerning the molar ratio of F⁻ anions to magnesium cations given above. The total amount of ethanol is selected such that the resulting concentration of the magnesium fluoride formed is in the broad range or in the preferred range given above.

The resulting reaction mixture is agitated, preferably stirred for a time sufficient to form the magnesium fluoride sol. Often, it is stirred for about 4 to 48 hours. The solution is preferably kept at a temperature in the range between 0°C and 30°C. It is advisable though not absolutely necessary to perform the reaction in the presence of an inert gas, e.g. nitrogen.

The pressure is not critical. It is preferred to perform the method at ambient pressure.

The resulting sol can be applied immediately for its purpose, e.g. for forming coatings: alternatively, it may be stored, e.g. for up to 4 weeks and even longer, and applied afterwards.

Another aspect of the present invention is a magnesium fluoride sol comprising water, a C1 to C3 alcohol or a C2 or C3 aliphatic diol, preferably ethanol, and magnesium fluoride, wherein the content of magnesium fluoride is from about 0.35 to about 0.55 Mol/liter and wherein the molar ratio between water and magnesium fluoride is from about 1:1 to about 3:1, more preferably, about 1.7:1 to about 2.7:1, and most preferably, from about 2:1 to about 2.5:1. Preferably, the magnesium fluoride sol according to the invention is free of trifluoroacetic acid. Sols containing ethanol as alcohol, especially containing ethanol as the sole alcohol, are preferred. The invention will now be described in view of this preferred embodiment.

Such sols are advantageous if compared with sols from prior art processes because they have a lower tendency to form solid gels, to settle and to agglomerate.

A preferred magnesium fluoride sol of the present invention is stable and contains preferably from about 0.35 to about 0.55 Mol/liter, more preferably from about 0.4 to about 0.5 Mol/liter of magnesium fluoride, and the molar ratio between water and magnesium fluoride is from about 1:1 to about 3:1, more preferably, from about 1.7:1 to about 2.7:1, and most preferably from about 2:1 to about 2.5:1. The sols are stable sols which means that they do not form solid gels if they are stored for at least 2 months at a temperature of 20°C.

The magnesium fluoride sols provided by the invention are transparent, colorless sols with a low viscosity and, preferably, stable.

They can be applied for all purposes for which such sols are applicable, e.g. by dip coating or spin coating to glass surfaces to provide an antireflective coating. They are especially suitable to provide coatings for glass coatins on top of solar cells. This use is another aspect of the present invention.

Still another object of the invention are solutions comprising or consisting of magnesium acetate, an organic solvent selected from the group consisting of C1 to C3 alcohols, C2 to C3 aliphatic diols, nitriles of formula R-CN wherein R is a C1 to C3 alkyl group, dinitriles of formula NC-R¹-CN wherein R is a C1 to C3 alkylene group and dimethyl formamide, and optionally water which solution further comprises carbon dioxide. Such solutions have the advantage that they can be prepared very quickly because carbon dioxide accelerates the dissolution of magnesium acetate, especially when introduced in the form of anhydrous magnesium acetate. Preferably, the content of magnesium acetate is from 50 % of the saturation concentration to the saturation concentration, the amount of water is 0 or from greater than 0 to 4 equivalents of the magnesium acetate contained - this means that per mole of magnesium acetate, 4 moles of water are contained -, the content of carbon dioxide is from about 0.1 % by weight to 10 % by weight of the solution, and the organic solvent preferably is the balance to 100 % by weight. Such solutions can be applied, for example, to provide magnesium fluoride sols or as starting material to perform organic reactions involving magnesium acetate, e.g. for the manufacture of anti-reflective oxide coatings on solar cells as decribed in US patent 7,767,253. It can also be used as filler for polymers, to produce a MgF2 catalyst, or to produce anticorrosive metal coatings.

The principle of the invention, namely to provide sols of magnesium fluoride containing a C1 to C3 aliphatic alcohol or a C2 or C3 aliphatic diol and water in specific amounts can be generalized to other solvents, e.g. those solvents mentioned above like nitriles of formula R-CN wherein R is a C1 to C3 alkyl group, dinitriles of formula NC-R¹-CN wherein R is a C1 to C3 alkylene group and dimethyl formamide.

Should the disclosure of any patents, patent applications, and publications which are incorporated herein by reference conflict with the description of the present application to the extent that it may render a term unclear, the present description shall take precedence.

The following examples are intended to explain the invention in further detail without the intention to limit it.

### Example 1 : Manufacture of a magnesium fluoride sol

a) 150 g anhydrous magnesium acetate were suspended in 850 g absolute ethanol and stirred. Continuously, dry ice was metered into the suspension over 5 hours (100 g of dry ice were added, but a significant amount of it evaporated). The suspension was filtered through paper. A portion of the clear solution was evaporated and dried at 130°C indicating a solid content of 10 % by weight. 100 g of the solution containing around 10 g of magnesium acetate (0.07 mol) and diluted it with 30 g ethanol. 26.7 g of a HF/Ethanol solution (10 % HF) were added, and the solution was stirred. After 4 hours a clear sol was obtained.
b) Magnesium acetate tetrahydrate was dissolved in ethanol (200 g in 1 liter of ethanol). The resulting solution was dried under reduced pressure (30 mbar) at 40°C. After this the water content amounted to 2 mol H₂O per mol l magnesium. 9 g of the obtained solid was re-suspended in 100 ml ethanol again and 15 g HF-ethanol (10 %) were added. After one day a clear suspension was obtained. The resulting MgF₂ sol, being kept on a shelf, was stable for around two months. It was thus more stable than the sol of example 1a.
c) 4.71 g Magnesium acetate (dried) was mixed with 4,75 g Magnesium acetate tetrahydrate. The blend was added to 93 g of ethanol. After one hour stirring 19.7 g of HF-Ethanol (10 %) was added. After one day, a clear sol resulted which proved very stable.

### Example 2 : Application of the sol of example 1 c) for providing an anti reflective coating

The sol of example 1c is applied on a glass surface which is a top coat of a solar cell by dip coating. The coated body is heated to about 400°C to provide a MgF₂ anti-reflective coating.

## Claims

1. A method for the manufacture of a magnesium fluoride sol by reaction of magnesium acetate or magnesium alcoholate and HF comprising a step of providing a solution comprising water and magnesium acetate or magnesium alcoho late in a molar ratio from about about 1:1 to about 3:1, preferably from 1.7:1 to about 2.7:1, and HF in a C1 to C3 aliphatic alcohol or a C2 or C3 aliphatic diol, preferably in ethanol, wherein the alcoholate is selected from methanolate, ethanolate and propanolate.

2. The method of claim 1 wherein the magnesium fluoride sol is manufactured by the reaction in ethanol of magnesium acetate and HF, and water and magnesium acetate are present in the solution in a molar ratio between about 2:1 to about 2.5:1.

3. The method of claim 1 or 2 wherein the molar ratio between fluoride anions and magnesium cations is equal to or greater than about 1.5, and equal to or lower than about 1.95:1.

4. The method of anyone of claims 1 to 3 wherein the molar ratio between fluoride anions and magnesium cations in the solution is between about 1.7:1 to about 1.9:1.

5. The method according to anyone of claims 1 to 4 wherein the HF is introduced into the reaction in the form of a solution of HF in ethanol.

6. The method according to claim 5 wherein the HF is contained in the ethanol/HF solution in a concentration of 5 to 15 % by weight, preferably 10±2 % by weight, relative to the total amount of HF and ethanol.

7. The method of anyone of claims 1 to 6 wherein the water is introduced into the reaction in the form of magnesium acetate tetrahydrate.

8. The method according to anyone of claims 1 to 7 wherein at least a part of the magnesium acetate is introduced into the reaction in the form of magnesium acetate tetrahydrate.

9. The method according to anyone of claims 1 to 8 wherein at least a part of the magnesium acetate is introduced into the reaction in the form of anhydrous magnesium acetate.

10. The method according to claim 9 wherein the dissolution of magnesium acetate is supported by carbon dioxide.

11. The method according to anyone of claims 1 to 10 wherein the concentration of magnesium fluoride in the resulting magnesium fluoride sol is from about 0.35 to about 0.55 Mol/liter, preferably from about 0.4 to 0.5 Mol/liter.

12. A magnesium fluoride sol comprising water, a C1 to C3 aliphatic alcohol or C2 or C3 aliphatic diol, preferably ethanol, and magnesium fluoride, wherein the content of magnesium fluoride is from about 0.35 to about 0.55 Mol/liter, preferably from about 0.4 to 0.5 Mol / liter, and wherein the molar ratio between water and magnesium fluoride is from about 1:1 to about 3:1, preferably from about 1.7:1 to about 2.7:1, and most preferably from about 2:1 to about 2.5:1.

13. The magnesium fluoride sol according to claim 12 which is free of trifluoroacetic acid.

14. The magnesium fluoride sol according to claim 12 or 13 comprising water, ethanol and magnesium fluoride, wherein the content of magnesium fluoride is from about 0.4 to 0.5 Mol / liter, and wherein the molar ratio between water and magnesium fluoride is from about about 2:1 to about 2.5:1, and which sol is stable when kept at 20°C for at least 1 week, preferably at least 4 weeks and longer.

15. A solution comprising or consisting of magnesium acetate, an organic solvent selected from the group consisting of C1 to C3 alcohols, nitriles of formula R-CN wherein R is a C1 to C3 alkyl group, dinitriles of formula NC-R¹-CN wherein R is a C1 to C3 alkylene group and dimethyl formamide, and optionally water which solution further comprises carbon dioxide.

16. Use of the sols according to any one of claims 12 to 15 and the sols obtained according to anyone of claims 1 to 11 for producing a magnesium fluoride coating on solar cells.
